(19) Europäisches Patentamt European Patent Office Office européen des brevets

(11) **EP 3 987 649 B1**

(12) **EUROPÄISCHE PATENTSCHRIFT**

(45) Veröffentlichungstag und Bekanntmachung des Hinweises auf die Patenterteilung:
**29.11.2023 Patentblatt 2023/48**

(21) Anmeldenummer: **20761748.1**

(22) Anmeldetag: **05.08.2020**

(51) Internationale Patentklassifikation (IPC):
**H02P 25/08** $^{(2016.01)}$     **H02P 21/00** $^{(2016.01)}$

(52) Gemeinsame Patentklassifikation (CPC):
**H02P 25/08; H02P 21/00; H02P 21/16;**
H02P 21/0025

(86) Internationale Anmeldenummer:
**PCT/EP2020/072035**

(87) Internationale Veröffentlichungsnummer:
**WO 2021/047832 (18.03.2021 Gazette 2021/11)**

(54) **VERFAHREN UND VORRICHTUNG ZUM BESTIMMEN EINER SÄTTIGUNGSCHARAKTERISTIK EINER SYNCHRONRELUKTANZMASCHINE**

METHOD AND DEVICE FOR DETERMINING A SATURATION CHARACTERISTIC OF A SYNCHRONOUS RELUCTANCE MACHINE

PROCÉDÉ ET DISPOSITIF DE DÉTERMINATION D'UNE CARACTÉRISTIQUE DE SATURATION D'UNE MACHINE À RÉLUCTANCE SYNCHRONE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.09.2019 EP 19197003**

(43) Veröffentlichungstag der Anmeldung:
**27.04.2022 Patentblatt 2022/17**

(73) Patentinhaber: **Siemens Aktiengesellschaft 80333 München (DE)**

(72) Erfinder: **WEIGEL, Thilo 90427 Nürnberg (DE)**

(74) Vertreter: **Siemens Patent Attorneys Postfach 22 16 34 80506 München (DE)**

(56) Entgegenhaltungen:
DE-A1-102012 223 441     DE-A1-102016 109 777
JP-A- 2002 095 289

EP 3 987 649 B1

**Beschreibung**

Die vorliegende Erfindung betrifft ein Verfahren zum Bestimmen einer Sättigungscharakteristik einer Synchronreluktanzmaschine. Des Weiteren betrifft die vorliegende Erfindung eine Vorrichtung zum Bestimmen einer Sättigungscharakteristik einer Synchronreluktanzmaschine.

Synchronreluktanzmotoren (synRM) besitzen mit Bezug auf den Läufer - prinzipiell bedingt - eine ausgeprägte richtungsabhängige Verteilung des magnetischen Leitwerts respektive der Induktivität. Üblicherweise und nach technischem Stand heute wird diese Anisotropie erstrangig durch eine im Läufer richtungsabhängige Materialverteilung des weichmagnetischen Eisens und durch Einbringen von Luftspalten (Flusssperren) erzielt. Resultierend, und damit diesen Motoren inhärent, ist eine stark nichtlineare Abhängigkeit des magnetischen Flusses vom Maschinenstrom. Bei einem kleinen Strom steigt der Fluss zunächst steil an. Mit Einsetzen der Sättigung in partiellen Bereichen des Läufers flacht der Anstieg dann ab. Dabei sind die Steilheit und stromabhängige Abflachung richtungsabhängig.

Für den Betrieb der Motorregelung ist die Kenntnis der Abhängigkeit des magnetischen Flusses vom Strom allgemein erforderlich: Ist ein Läuferlagesensor vorhanden, so müssen zumindest die Verstärkungen der Stromregler adaptiv am Arbeitspunkt mitgeführt sein. Für den Betrieb mit bestmöglichem Wirkungsgrad wird die Information des günstigsten Stromarbeitspunktes abhängig vom verlangten Drehmoment benötigt. Auch dieser geht letztlich aus den Flussfunktionen hervor. Soll schließlich der Synchronreluktanzmotor ohne Läuferlagesensor betrieben werden, so müssen zur Schätzung der Läuferposition aus Spannung und Strom auch in den Motormodellen die Sättigungsfunktionen bekannt sein. Die Ermittlung der Flussfunktionen ist daher ein essentielles und zentrales Thema.

In diesem Zusammenhang ist es aus dem Stand der Technik bekannt, dass die Flussfunktionen aus den FEM-Daten des Maschinendesigns berechnet werden. Ferner ist es aus dem Stand der Technik die Vermessung der Flussfunktionen auf Prüfständen und mittels Messprogrammen bekannt. Hierbei wird der zu vermessende Prüfling mit einem Läuferlagesensor ausgerüstet und mit einer Antriebsmaschine gekuppelt. Bei eingeprägter Drehzahl können dann bezogen auf den Läufer des Prüflings Ströme eingeprägt und die induzierten Statorspannungen gemessen werden. Aus den Spannungen können bei bekannter Drehzahl (Frequenz) die Statorflüsse berechnet werden.

Die JP 2002 095289 A lehrt eine Motorsteuerung mit einer Klassifizierungseinrichtung zur Klassifizierung eines zu betreibenden Motors und Mittel zur Steuerung des Motors, um den Motor basierend auf einer Beurteilung der Klassifizierung zu betreiben. Die obige Klassifizierungseinrichtung weist Mittel zur Ermittlung des Sättigungsgrades des Motors auf, wobei der Sättigungsgrad des Motors derart ermittelt wird, dass der Grad der Differenz der magnetischen Sättigung des Motors, hervorgerufen durch unterschiedliche Stromflüsse in den Windungen des Motors bei verschiedenen Anwendungsszenarien, aufgezeigt wird.

Es ist Aufgabe der vorliegenden Erfindung, eine Lösung aufzuzeigen, wie die Sättigungscharakteristik einer Synchronreluktanzmaschine auf einfache Weise zuverlässiger bestimmt werden kann.

Diese Aufgabe wird erfindungsgemäß durch ein Verfahren sowie durch eine Vorrichtung mit den Merkmalen gemäß den unabhängigen Ansprüchen gelöst. Vorteilhafte Weiterbildungen der Erfindung sind in den abhängigen Ansprüchen angegeben.

Ein erfindungsgemäßes Verfahren dient zum Bestimmen einer Sättigungscharakteristik einer Synchronreluktanzmaschine. Das Verfahren umfasst das Anlegen einer Spannungssequenz an einen Stator der Synchronreluktanzmaschine mittels eines Pulswechselrichters. Durch das Anlegen der Spannungssequenz werden Statorflüsse in den Stator eingeprägt. Dabei wird die Spannungssequenz derart angelegt, dass sich während des Anlegens der Spannungssequenz auf einen Läufer der Synchronreluktanzmaschine wirkende Drehmomente aufheben. Zudem umfasst das Verfahren das Messen von elektrischen Strömen, welche aus den Statorflüssen resultieren. Ferner umfasst das Verfahren das Bestimmen der Sättigungscharakteristik eines Läufers anhand der Statorflüsse und der gemessenen Ströme.

Vorliegend soll eine antriebsautarke Bestimmung der Sättigungscharakteristik der Synchronreluktanzmaschine (synRM) durchgeführt werden. Die Synchronreluktanzmaschine ist eine Drehstrom-Synchronmaschine und umfasst den Stator sowie den zu dem Stator drehbaren Läufer beziehungsweise Rotor. Der Stator kann verteilte Wicklungen aufweisen. Insbesondere umfasst die Synchronreluktanzmaschine keinen Dämpferkäfig. Der Läufer ist magnetisch anisotrop aufgebaut. Insbesondere kann der Läufer entsprechende Flusssperrelemente, also luftgefüllte Bereiche, aufweisen, die derart angeordnet sind, dass ein richtungsabhängiger magnetischer Leitwert resultiert.

Die Kenntnis und Modellbildung der bei der Synchronreluktanzmaschine inhärent nichtlinearen Beziehung von Statorfluss und Statorstrom ist von entscheidender Bedeutung, wenn die Synchronreluktanzmaschine robust und performant betrieben werden soll. Insbesondere ist dies relevant, wenn die Synchronreluktanzmaschine ohne Läuferlagesensor betrieben werden soll. Für eine antriebsautarke Vermessung der Charakteristik sind grundlegend zwei Methoden möglich. Gemäß einer Methode können Statorströme eingeprägt werden und die abhängigen Statorflüsse können über die induzierten Spannungen gemessen werden. Problematisch hierbei ist die Notwendigkeit dynamisch arbeitender Stromregler ohne genaue Kenntnis der Sättigung. Gemäß dem erfindungsgemäßen Verfahren werden mittels aufgeschalteter Spannungssequenzen die Statorflüsse eingeprägt und die resultierenden abhängigen Ströme gemessen. Hierbei können die Stromregler entfallen.

Bei dem Verfahren werden an dem Stator beziehungsweise an den Statorwicklungen Spannungssequenzen angelegt. Diese Spannungssequenzen können jeweils mehrere Spannungspulse aufweisen. Zum Anlegen der Spannungspulse kann der Pulswechselrichter verwendet werden, mittels welchem Spannungszeiger ausgegeben werden. Durch die Spannungssequenz beziehungsweise die Spannungspulse werden Statorflüsse in den Stator eingeprägt. Des Weiteren werden die elektrischen Ströme, die aus den Statorflüssen resultieren gemessen. Hieraus kann dann die Sättigungscharakteristik der Synchronreluktanzmaschine bestimmt werden. Diese kann aus dem nichtlinearen Zusammenhang der Statorflüsse und der Statorströme abgeleitet werden.

Dabei ist vorgesehen, dass die Spannungssequenz beziehungsweise die Spannungspulse derart ausgegeben werden, dass sich die jeweiligen Drehmomente, die auf den Läufer wirken, aufheben. Durch die jeweiligen Spannungspulse wird ein Drehmoment erzeugt, welches auf den Läufer wirkt. Dabei werden die Spannungspulse so bestimmt, dass sich die Drehmomente, welche durch die jeweiligen Spannungspulse ergeben, in Summe aufheben. Dies bedeutet, dass die Läuferposition unverändert bleibt. Für diese Zielsetzung ist die gesamte Spannungssequenz beziehungsweise Impulssequenz als Folge kurzer Subsequenzen definiert. Das vorgestellte Verfahren ist im zeitlichen Mittel also bevorzugt drehmomentfrei. Somit können Synchronreluktanzmaschinen im Stillstand bei frei drehbarem wie auch festgebremstem Läufer in der eingebauten technischen Applikation vermessen werden.

Mit der vorliegenden Erfindung können die Flussfunktionen autark vom Antriebsumrichter selbst vermessen werden und die für den Regelungsbetrieb benötigten Flussmodelle (tabellarisch oder geschlossen) identifiziert werden. Zudem entfällt die Konfiguration der zu vermessenden Maschine mit einem Läuferlagesensor ebenso wie deren Einbindung in einen Prüfstand mit gekoppelter Antriebsmaschine. Darüber hinaus ist das Verfahren von kurzer Messdauer. Je nach gewünschter Auflösung und Anzahl von Messpunkten werden wenige Sekunden bis wenige Minuten benötigt. Insgesamt kann somit die Sättigungscharakteristik der Synchronreluktanzmaschine auf einfache Weise zuverlässiger bestimmt werden.

Bevorzugt wird vor dem Anlegen der Spannungssequenz eine Lage des Läufers bestimmt und ein statorfestes Koordinatensystem wird initial auf die bestimmte Lage ausgerichtet. Vor Beginn der eigentlichen Messsequenz kann zunächst mit einem Verfahren nach Stand der Technik die Läuferposition mit Bezug auf die elektrischen Achsen des Stators bestimmt werden. Des Weiteren kann das statorfeste Koordinatensystem zur Aufschaltung der Messsequenz initial auf diese Position ausgerichtet werden. Über die sich dann anschließende Messsequenz bleibt die Läuferposition unverändert. Auf diese Weise können die Messungen präzise durchgeführt werden.

Gemäß einer Ausführungsform ist vorgesehen, dass beim Anlegen der Spannungssequenz eine Mehrzahl von Spannungszeigern ausgegeben wird und für jeder der Spannungszeiger ein Messwert für den elektrischen Strom bestimmt wird. Eine Subsequenz kann eine kurze Sequenz aufgeschalteter Spannungszeiger umfassen. Die Flussimpulse können mittels geschalteter Spannungszeiger des Pulswechselrichters eingeprägt werden. Die Erfassung des elektrischen Stroms beziehungsweise eines Strommesswerts kann über die Dauer eines geschalteten Nullzeigerintervalls erfolgen. Im Folgeintervall kann durch eine Pulssperre der Strom über die Freilaufdioden wieder abgebaut werden. Je Subsequenz kann dabei genau ein Messpunktergebnis des abhängigen Stromes vom unabhängigen Fluss bestimmt werden. Verschwindet über jede Subsequenz das zweite Zeitintegral der mit Aufschaltung der Impulse auf den Läufer wirkenden Drehmomente, so ist die Änderung der Läuferposition identisch Null.

Mittels nachgeschalter Interpolation kann das Abhängigkeitsverhältnis umgekehrt und für unabhängig vorgegebene Stützstellen des Stromes die abhängigen Statorflüsse berechnet werden. Bei Verwendung eines Flussmodells in geschlossener Form kann im Anschluss ein Parameterschätzverfahren durchgeführt werden. Abhängig vom verwendeten Flussmodell (geschlossen oder tabellarisch) können der Messung nachgeschaltet mittels numerischer Standardverfahren die benötigten Modellparameter berechnet werden oder zur Laufzeit benötigte Echtzeitwerte (beispielsweise Fluss über Strom) direkt aus den Messtabellen interpoliert werden.

In einer weiteren Ausführungsform werden beim Anlegen der Spannungssequenz vier Spannungszeiger ausgegeben. Die Spannungszeiger können so bestimmt werden, dass die hieraus resultierenden Flusszeiger alle den gleichen Betrag aufweisen. Zudem können die Spannungszeiger so bestimmt werden, dass die Flusszeiger in vier achsensymmetrische Richtungen zeigen. Hieraus resultieren dann vier Drehmomente von ebenfalls konstant gleichem Betrag und wechselnden Vorzeichen. Somit kann erreicht werden, dass sich die Drehmomente aufheben.

In einer weiteren Ausführungsform werden beim Anlegen der Spannungssequenz acht Spannungszeiger ausgegeben. Unter realen Bedingungen kann die ideale mechanische Bewegungsgleichung kann das auftretende Reibmoment beeinflusst werden. Dies beeinflusst die Nullbilanz der Positionsänderung des Läufers beziehungsweise das Aufheben der Drehmomente. Durch eine Verlängerung der Subsequenz auf acht Impulse kann dieser Effekt gemindert werden.

Weiterhin ist vorteilhaft, wenn eine Impulsdauer, während welcher die jeweiligen Spannungszeiger ausgegeben werden, in Abhängigkeit von einer geschätzten Auslenkung des Läufers bestimmt wird. Bei der Annahme einer konstant geschalteten Spannung steigen bei vernachlässigter Sättigung Fluss und Strom linear mit der Zeit. Bei realer Berücksichtigung der Sättigung wächst die Steilheit des Stroms über der Impulsdauer. Das Drehmoment, als Produkt von Fluss und Strom, steigt somit über der Zeit wenigstens quadratisch. Mit Zugrundelegung des am Impulsende erreichten Drehmomentnennwerts, der zur Einprägung des Flussnennwerts mindestbenötigten Impulsdauer sowie der mechanische Nennanlaufzeit kann die resultierende Positionsauslenkung über den geschalteten Impuls abgeschätzt werden. Der Durchgriff des Statorstroms auf den Statorfluss schwindet frequenzabhängig. Ursache sind Wirbelströme im Stator- und Läufereisen welche nach Lenzscher Regel so induziert werden, dass sie einer Änderung des Flusses entgegenwirken (Transformatoreffekt). Gegenüber dem quasistationären Betrieb unter Drehfeldbedingungen enthält der Statorstrom bei impulsförmiger Anregung daher additive Anteile, die nicht mit dem Fluss verkoppelt sind. Um diesen Effekte gering zu halten, darf die zeitliche Ausdehnung der Impulse nicht beliebig klein gemacht werden.

In einer Ausführungsform wird die Spannungssequenz derart vorgeben, dass die resultierenden Statorflüsse äquidistant sind. Gemäß einer alternativen Ausführungsform kann die Spannungssequenz in Abhängigkeit von bekannten Sättigungscharakteristiken von Synchronreluktanzmaschinen vorgegeben werden. Die Vorgabe der unabhängigen Flüsse je Messpunkt kann äquidistant oder basierend auf a priori Kenntnis typischer Sättigungscharakteristiken von Synchronreluktanzmaschinen erfolgen. Dazu kann bei kleinem Flussbetrag die Distanz der Vorgaben zunächst größer gewählt und dann mit steigendem Flussbetrag verdichtet werden. Bei dieser a priori Vorgabe resultiert eine homogenere Verteilung der Strommesswerte.

Weiterhin ist vorteilhaft, wenn die Ströme für einen ersten Quadraten des Läufers bestimmt werden und die Sättigungscharakteristik anhand einer bekannten Symmetrie des Läufers bestimmt wird. Als Resultat kann beispielsweise in Tabellenform die Messpunktergebnisse der abhängigen Ströme von den vorgegebenen Flüssen über den ersten Quadranten vorliegen. Aufgrund der bei Synchronreluktanzmaschine bestehenden Symmetrien beschreiben diese die Sättigungscharakteristik vollständig.

Auf Grundlage der bestimmten Sättigungscharakteristik des Läufers kann dann die Synchronreluktanzmaschine betrieben werden. Hierbei ist insbesondere vorgesehen, dass beim Betrieb der Synchronreluktanzmaschine kein Läuferlagesensor verwendet wird.

Eine erfindungsgemäße Vorrichtung dient zum Bestimmen einer Sättigungscharakteristik einer Synchronreluktanzmaschine. Die Vorrichtung umfasst einen Pulswechselrichter zum Anlegen einer Spannungssequenz an einen Stator der Synchronreluktanzmaschine und zum Einprägen von Statorflüssen. Dabei ist der Pulswechselrichter dazu ausgelegt, die Spannungssequenz derart anzulegen, dass sich während des Anlegens der Spannungssequenz auf einen Läufer der Synchronreluktanzmaschine wirkende Drehmomente aufheben. Zudem umfasst die Vorrichtung eine Messeinrichtung zum Messen von elektrischen Strömen, welche aus den Statorflüssen resultieren. Ferner ist die Vorrichtung dazu ausgebildet, die Sättigungscharakteristik anhand der Statorflüsse und der gemessenen Ströme zu bestimmen.

Im Falle geschlossener Flussmodelle können die benötigten Algorithmen antriebsgeräteintern wie auch extern implementiert sein. Bei externer Implementierung werden die aufgezeichneten Messpunkte zunächst in das Engineering-Tool hochgeladen. Nach erfolgter Parameterschätzung werden die Modellparameter in den Antrieb zurückgeladen. Durch die Vorrichtung beziehungsweise durch das Verfahren werden bei eingegrenzter Bauart nun auch Fremdmaschinen von Drittanbietern ohne eine notwendige werksseitige Vermessung betreibbar sein.

Die mit Bezug auf das erfindungsgemäße Verfahren vorgestellten bevorzugten Ausführungsformen und deren Vorteile gelten entsprechend für die erfindungsgemäße Vorrichtung.

Weitere Merkmale der Erfindung ergeben sich aus den Ansprüchen, den Figuren und der Figurenbeschreibung.

Die Erfindung wird nun anhand von bevorzugten Ausführungsbeispielen sowie unter Bezugnahme auf die beigefügten Zeichnungen näher erläutert. Dabei zeigen:

FIG 1    eine schematische Darstellung einer Synchronreluktanzmaschine sowie einer Vorrichtung zum Bestimmen einer Sättigungscharakteristik der Synchronreluktanzmaschine;

FIG 2    eine schematische Darstellung von vier Flusszeigern infolge von Spannungspulsen, welche auf einen Stator der Synchronreluktanzmaschine aufgeschaltet werden, und die hieraus resultierenden Ströme;

FIG 3    auf den Läufer der Synchronreluktanzmaschine wirkenden Drehmomente bei vier Spannungspulsen sowie den resultierenden Verlauf von Wellendrehzahl und Wellenposition in Abhängigkeit von der Zeit;

FIG 4    auf den Läufer der Synchronreluktanzmaschine wirkenden Drehmomente bei acht Spannungspulsen sowie den resultierenden Verlauf von Wellendrehzahl und Wellenposition in Abhängigkeit von der Zeit;

FIG 5    einen zeitlichen Verlauf des Flusses und des Stroms bei einem aufgeschalteten Spannungspuls;

FIG 6    eine schematische Darstellung der Vorgabe von Flussimpulsen in Richtung der Läuferquerachse auf Bahnen;

FIG 7    ein schematisches Ablaufdiagramm zur Identifizierung der Läuferposition und des Abgleichs eines Koordinatensystems;

FIG 8    eine äquidistant Vorgabe der Anteile des Flusses bezüglich der Achsen d und q;

FIG 9    die resultierende Abbildung der Strommesswerte bei der Vorgabe gemäß FIG 8;

FIG 10    eine Vorgabe der Anteile des Flusses nach a priori Kenntnis typischer Fluss-Sättigungsverläufe;

FIG 11    die resultierende Abbildung der Strommesswerte bei der Vorgabe gemäß FIG 10; und

FIG 12    ein schematisches Ablaufdiagramm eines Verfahrens zum Bestimmen der Sättigungscharakteristik der Synchronreluktanzmaschine.

In den Figuren werden gleiche oder funktionsgleiche Elemente mit den gleichen Bezugszeichen versehen.

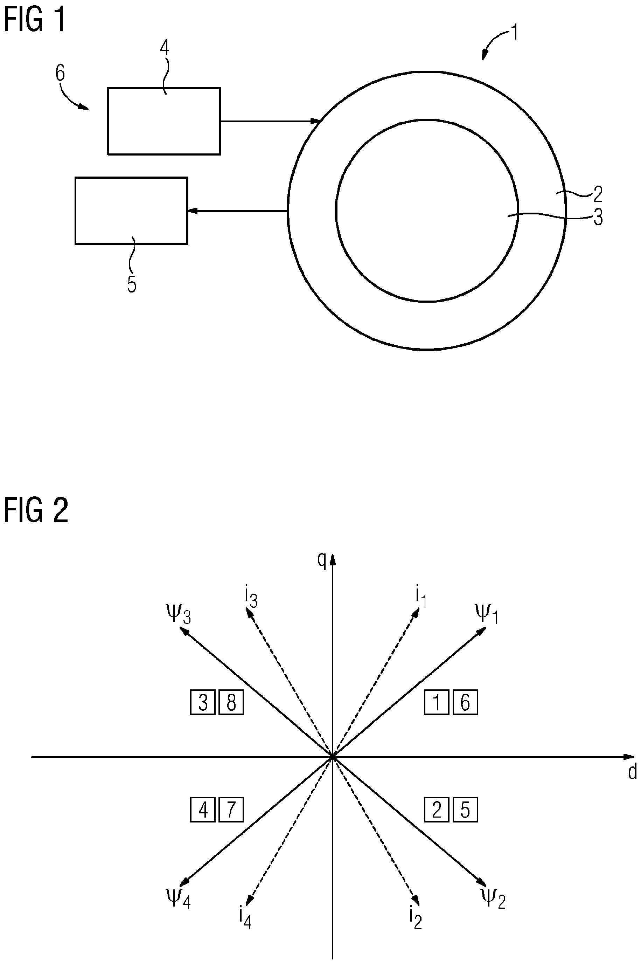

FIG 1 zeigt in einer stark vereinfachten Darstellung eine Synchronreluktanzmaschine 1, welche einen Stator 2 und einen Läufer 3 aufweist. Die Synchronreluktanzmaschine 1 kann mit einem Pulswechselrichter 4 angesteuert werden.

Synchronreluktanzmaschinen 1 ohne Dämpferkäfig weisen eine inhärent nichtlineare Beziehung von Statorfluss und Statorstrom auf. Diese Sättigungscharakteristik der Synchronreluktanzmaschine 1 soll bestimmt werden, um die Synchronreluktanzmaschine robust und performant ohne Läuferlagesensor zu betreiben. Hierzu werden mit dem Pulswechselrichter 4 Spannungssequenzen an einem Stator 2 der Synchronreluktanzmaschine angelegt. Hieraus resultieren Statorflüsse in dem Stator 2. Des Weiteren werden elektrische Ströme $i_1$ bis $i_4$ gemessen, welche aus den Statorflüssen $\Psi_1$ bis $\Psi_4$ resultieren. Die Ströme $i_1$ bis $i_4$ werden mittels einer Messeinrichtung 5 gemessen. Hieraus kann dann die Sättigungscharakteristik der Synchronreluktanzmaschinen abgeleitet werden. Die Messeinrichtung 5 und der Pulswechselrichter 4 bilden zusammen eine Vorrichtung 6.

Zunächst wird Erzeugung der Spannungssequenz beziehungsweise Subsequenz erläutert. Eine Subsequenz kann eine kurze Sequenz aufgeschalteter Spannungszeiger umfassen. Die dabei auf den Läufer 3 wirkenden Drehmomente sind derart zu bestimmen, dass sich diese im zweiten Zeitintegral aufheben. Den aufgeschalteten Spannungszeigern liegt der unabhängig vorgegebene Flusswert als "Generatorwert" zugrunde. Ergebnis der Subsequenz ist der Messwert für den Strom in Abhängigkeit vom vorgegeben Generatorwert des Flusses. Für die Generierung der Subsequenz können die bei der Synchronreluktanzmaschine 1 vorhandenen magnetischen Symmetrien ausgenutzt werden: Die Abbildung der Statorströme auf die Statorflüsse sowie in Umkehrung der Flüsse auf die Ströme sind mit Bezug auf die Läuferachsen achsensymmetrisch.

FIG 2 zeigt für vier aufgeschaltete Flusszeiger $\Psi_1$, $\Psi_2$, $\Psi_3$, und $\Psi_4$ konstant gleichen Betrags und achsensymmetrischer Richtungen die resultierenden Ströme $i_1$, $i_2$, $i_3$, und $i_4$. Die Statorflüsse $\Psi_1$ bis $\Psi_4$ beziehungsweise die Flusszeiger und die Ströme $i_1$ bis $i_4$ sind dabei bezüglich der Achsen d und q der Synchronreluktanzmaschine dargestellt. Mit gegebenen Symmetrien sind die zugehörigen resultierenden Drehmomente $M_1$ bis $M_4$ ebenfalls konstant gleichem Betrag und wechselndem Vorzeichen: $M_1 = M_4 = -M_2 = -M_3$.

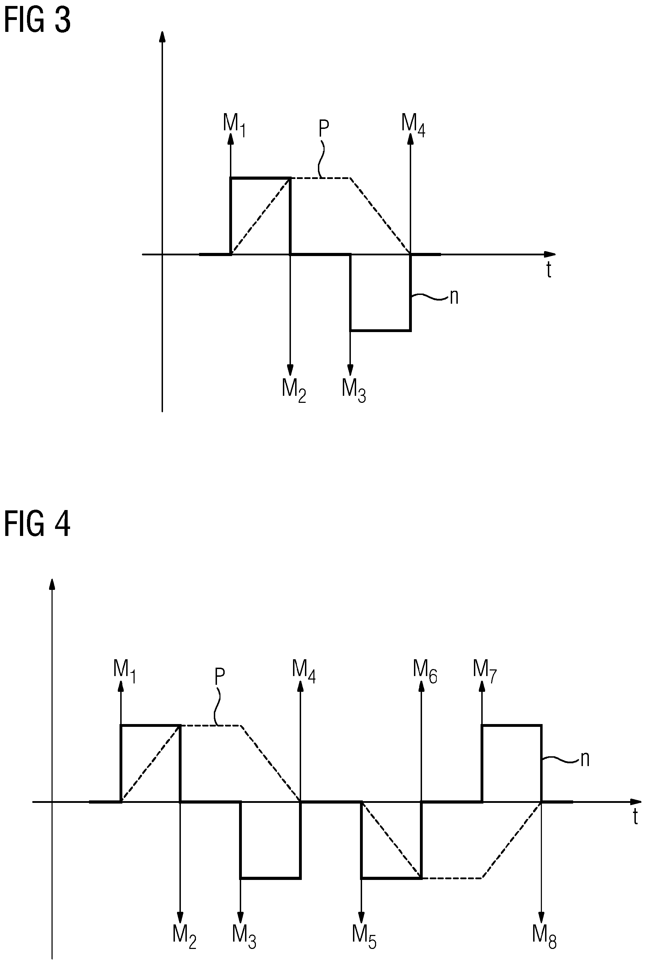

In zunächst vereinfachter Betrachtung seien die durch die geschalteten Impulse auf den Läufer wirkenden Drehmomente $M_1$ bis $M_4$ ideale Dirac-Impulse. Hierzu zeigt FIG 3 den resultierenden Verlauf von Wellendrehzahl n und Wellenposition P in Abhängigkeit von der Zeit t. Mit der gewählten Impulsfolge verschwindet wie gefordert das Doppelintegral des Drehmoments und damit die Änderung der Position des Läufers.

Nach der Darstellung von FIG 2 kann zur Vermessung der Abhängigkeit des Stromes $i_k$ vom Fluss $\Psi_k$ eine 4-pulsige Subsequenz beschrieben werden:

$$\mathrm{SEQ4}(\Psi_k) := \{\Psi_k,\ \Psi^*_k,\ -\Psi^*_k,\ -\Psi_k\}.$$

Das Messpunktergebnis aus den vier Stromwerten resultiert zu:

$$i_k = 1/2\ (i_{k,1} - i_{k,4}).$$

Unter realen Bedingungen ist die ideale mechanische Bewegungsgleichung durch das auftretende Reibmoment "gestört". Dies beeinflusst die Nullbilanz der Positionsänderung. Auch bewirken die beiden in der Sequenzmitte aufgeschalteten Impulse aufgrund der dort wirksamen Positionsauslenkung gegenüber den Randimpulsen einen abweichenden Betrag im Drehmoment. Durch eine Verlängerung der Subsequenz auf acht Impulse kann dieser Effekt gemindert werden:

$$\mathrm{SEQ8}(\Psi_k) := \{\Psi_k, \; \Psi^*_k, \; -\Psi^*_k, \; -\Psi_k, \; \Psi^*_k, \; \Psi_k, \; -\Psi_k, \; -\Psi^*_k\}.$$

Das Messpunktergebnis aus den acht Strommesswerten:

$$i_k = 1/4 \; (i_{k,1} - i_{k,4} + i^*_{k,5} - i^*_{k,8}).$$

Idealisiert ergibt sich der in FIG 3 und FIG 4 gezeigte Verlauf von Drehmoment Drehmomente $M_1$ bis $M_4$, Drehzahl n und Position P.

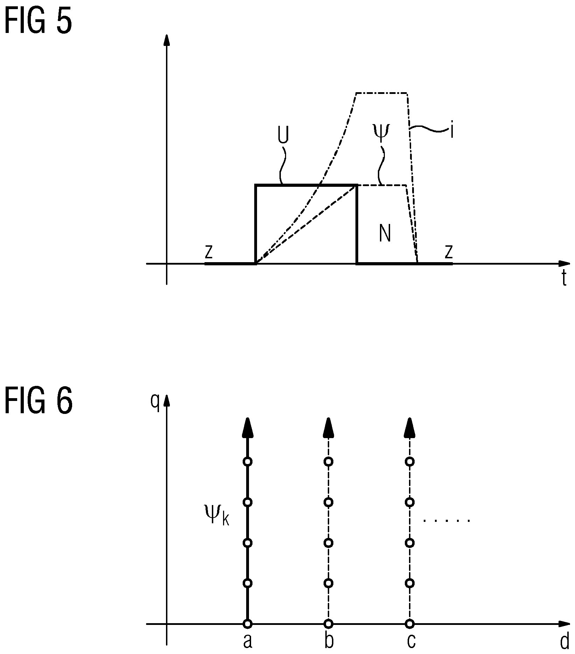

Nachfolgend werden die real geschalteten Impulsdauern betrachtet. Die Flussimpulse werden mittels geschalteter Spannungszeiger U des Pulswechselrichters eingeprägt. Die Erfassung des Strommesswerts erfolgt über die Dauer eines geschalteten Nullzeigerintervalls N. Im Folgeintervall wird durch Pulssperre z der Strom über die Freilaufdioden wieder abgebaut. Dies ist in FIG 5 zu erkennen. Bei Annahme einer konstant geschalteten Spannung U steigen bei vernachlässigter Sättigung Fluss $\Psi$ und Strom i linear mit der Zeit t. Bei realer Berücksichtigung der Sättigung wächst die Steilheit des Stromes i über der Impulsdauer. Das Drehmoment, als Produkt von Fluss $\Psi$ und Strom i, steigt somit über der Zeit t wenigstens quadratisch.

Mit Zugrundelegung des am Impulsende erreichten Drehmomentnennwerts, der zur Einprägung des Flussnennwerts mindestbenötigten Impulsdauer sowie der mechanische Nennanlaufzeit kann die resultierende Positionsauslenkung über den geschalteten Impuls abgeschätzt werden. Hierzu zeigt die nachfolgende Tabelle für 50 Hz Synchronreluktanzmaschinen unterschiedlicher Leistung $P_n$ die mechanischen Nennlaufzeigen $T_{mech}$ sowie die Auslenkung $\varphi$.

| $P_n$ / kW | $T_{mech}$ / mS | $\varphi$ / ° |
|---|---|---|
| 0.55 | 90 | 0,33 |
| 3,0 | 82 | 0,37 |
| 15 | 102 | 0,29 |
| 45 | 284 | 0, 1 |

Bei festgehaltenem Endwert steigt die Positionsauslenkung quadratisch mit dem Quotienten der tatsächlich aufgeschalteten Impulsdauer zum Mindestwert. Der Mindestwert kann mit dem Kehrwert der Nennkreisfrequenz abgeschätzt werden. Bei 50 Hz Maschinen resultiert somit eine Mindestdauer von 3.2 ms.

Der Durchgriff des Statorstroms auf den Statorfluss schwindet frequenzabhängig. Ursache sind Wirbelströme im Stator- und Läufereisen welche nach Lenzscher Regel so induziert werden, dass sie einer Änderung des Flusses entgegenwirken (Transformatoreffekt). Gegenüber dem quasistationären Betrieb unter Drehfeldbedingungen enthält der Statorstrom bei impulsförmiger Anregung daher additive Anteile, die nicht mit dem Fluss verkoppelt sind. Um diesen Effekte gering zu halten, darf die zeitliche Ausdehnung der Impulse nicht beliebig klein gemacht werden. Weiter kann optional mittels einer Drehfeldreferenzmessung in einem gesteuerten Strom-Frequenzeingeprägten Betrieb (I/F-betrieb) unter Leerlaufbedingungen der Faktor zwischen beiden Messarten bestimmt werden. Dazu wird in beiden Messarten ein gleicher Fluss vorgegeben und das Verhältnis der benötigten Ströme bestimmt. Mit diesem Faktor kann die impulsförmig gemessene Sättigungscharakteristik skaliert werden.

Aufgrund der magnetischen Symmetrien ist für eine vollständige Vermessung die Vorgabe des Flusses $\Psi_k$ (Generatorwert der Subsequenz) über den ersten Quadrant ausreichend. Die Vorgaben können in Richtung der Läuferquerachse auf Bahnen a, b, c und so weiter abgefahren werden. Dies ist in FIG 6 veranschaulicht.

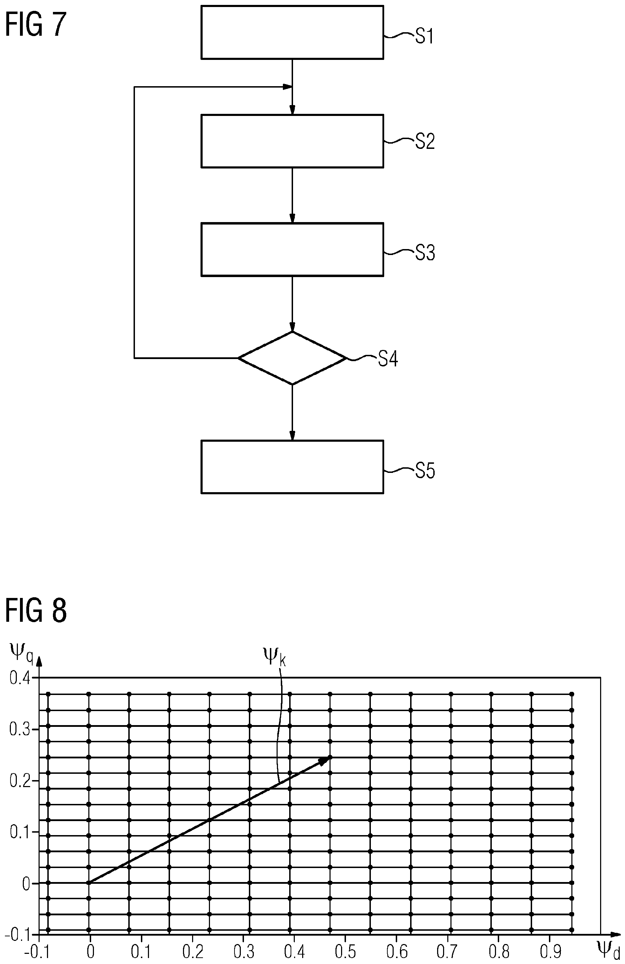

Im Verlauf der Messsequenz kann bei Bedarf die Läuferposition wiederholt identifiziert und der Abgleich des Koordinatensystems aktualisiert werden. Dies wird nachfolgend anhand des Ablaufdiagramms von FIG 7 erläutert. In einem Schritt S1 wird ein Zähler auf 0 gesetzt und die erste Messsequenz betrachtet. In einem Schritt S2 erfolgen dann die Identifikation der Läuferlage und die Initialisierung des Koordinatensystems. In einem Schritt S3 wird der Zähler erhöht und die nachfolgende Messsequenz betrachtet. Hierbei wird in einem Schritt S4 überprüft, ob ein neuer Abgleich notwendig ist. Ist dies der Fall, wird das Verfahren mit dem Schritt S2 weitergeführt, ansonsten wird die Messung beendet und in einem Schritt S5 wird das Ergebnis ausgegeben. Dieses Ergebnis kann in Form einer Tabelle ausgegeben werden, in welcher die Messwerte des Flusses über den Strom eingetragen sind.

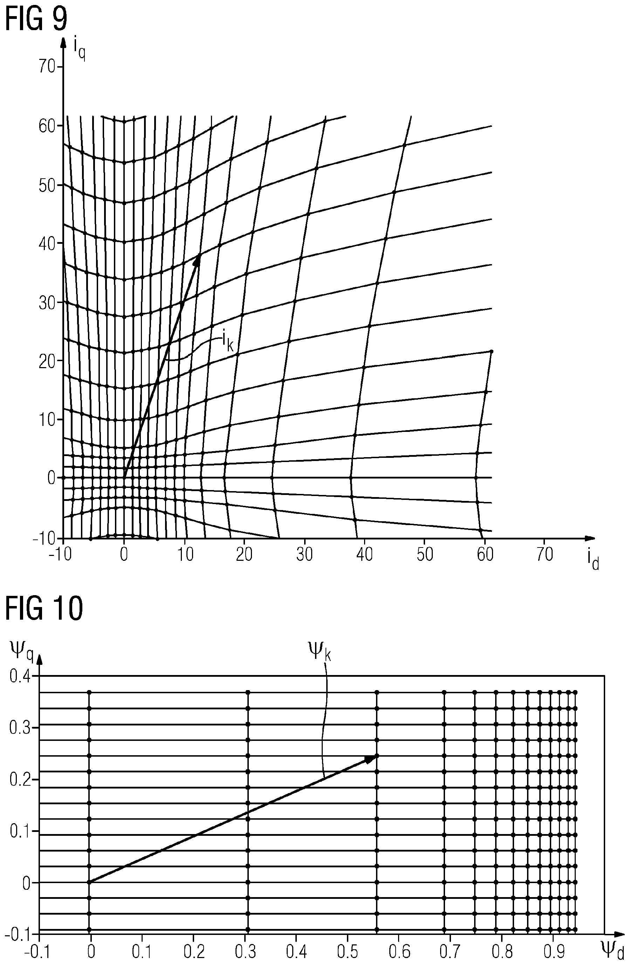

Die Vorgabe der Messpunktverteilung kann äquidistant sein. Hierzu zeigt FIG 8 beispielhaft eine äquidistante Vorgabe der Anteile des Flusses $\Psi_k$ bezüglich der Achsen d und q. FIG 9 zeigt die resultierende Abbildung der Strommesswerte.

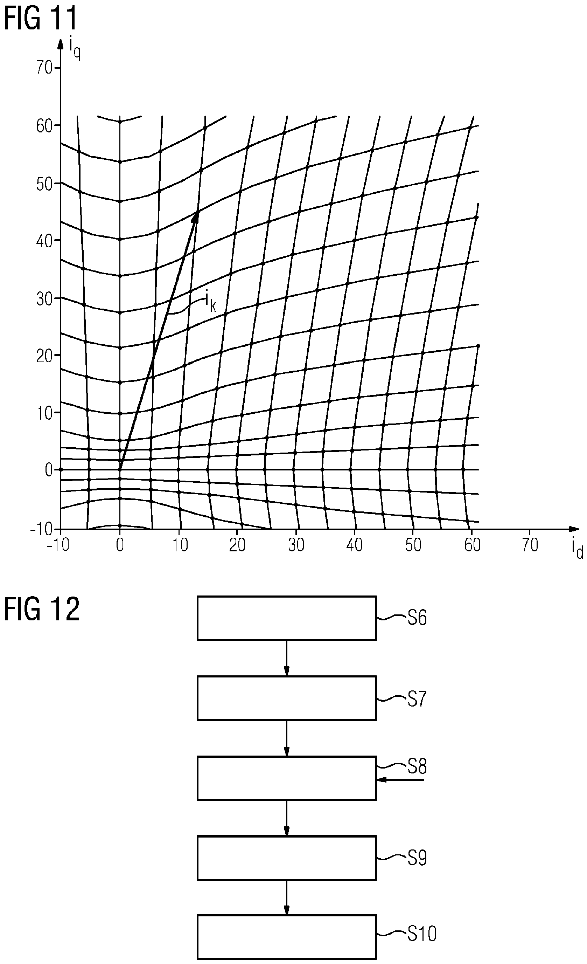

Die Vorgabe der Messpunktverteilung kann alternativ basierend auf a priori Kenntnis der für Synchronreluktanzmaschinen typischen Sättigungsverläufe erfolgen. Dazu kann bei kleinem Flussbetrag die Distanz der Vorgaben zunächst größer gewählt und dann mit steigendem Flussbetrag verdichtet werden. Hierzu zeigt FIG 10 die Vorgabe der Flussimpulse nach a priori Kenntnis typischer d-Fluss-Sättigungsverläufe. FIG 11 zeigt die resultierende Abbildung der Strommesswerte. Bei der a priori Vorgabe resultiert eine homogenere Verteilung der Strommesswerte.

FIG 12 zeigt ein schematisches Ablaufdiagramm für die Bestimmung der Sättigungscharakteristik der Synchronreluktanzmaschine. In einem Schritt S6 wird das Ergebnis der Messsequenz bereitgestellt. Das Ergebnis der Messsequenz ist die in Tabellenform über alle angefahrenen Punkte vorliegende Zuordnung des unabhängig vorgegebenen Flusses zum abhängig gemessenen Strom. Die Tabelle kann in beide Richtungen gelesen, respektive ausgewertet, werden. Beispielsweise können die Zeilen und Spalten der Tabelle in einem Schritt S7 vertauscht werden.

Mittels nachgeschalter Interpolation nicht äquidistant gemessener Daten in beliebig vorgegebenen Stützstellen (nach numerischen Standardverfahren) kann das Abhängigkeitsverhältnis der Messung umgekehrt, und für die nun unabhängig vorgebbaren Ströme (Stützstellen) die jeweils abhängigen Statorflüsse interpoliert werden (Schritt S8). In einem Schritt S9 kann dann die Tabellen ausgegeben werden, in welcher der Fluss für die Stützstellen des Stroms eingetragen ist. Bei Verwendung eines Flussmodells in geschlossener Form kann in einem weiteren Schritt ein Parameterschätzverfahren in einem Schritt S10 durchgeführt werden. Die Interpolation und/oder das Parameterschätzverfahren können dabei antriebsintern oder antriebsextern implementiert sein. Die Algorithmen (numerische Standardverfahren) können bei Drittanbietern erworben oder selbst implementiert werden.

**Patentansprüche**

1. Verfahren zum Bestimmen einer Sättigungscharakteristik einer Synchronreluktanzmaschine (1) mit den Schritten:

    - Anlegen einer Spannungssequenz an einen Stator (2) der Synchronreluktanzmaschine (1) mittels eines Pulswechselrichters (4) und hierdurch Einprägen von Statorflüssen ($\Psi_1$ bis $\Psi_4$),
    - Messen von elektrischen Strömen ($i_1$ bis $i_4$), welche aus den Statorflüssen ($\Psi_1$ bis $\Psi_4$) resultieren und
    - Bestimmen der Sättigungscharakteristik anhand der Statorflüssen ($\Psi_1$ bis $\Psi_4$) und der gemessenen Ströme ($i_1$ bis $i_4$),

    **dadurch gekennzeichnet, daß** die Spannungssequenz derart angelegt wird, daß sich während des Anlegens der Spannungssequenz auf einen Läufer (3) der Synchronreluktanzmaschine (1) wirkende Drehmomente (M i bis M4 ) aufheben.

2. Verfahren nach Anspruch 1, **dadurch gekennzeichnet, dass** vor dem Anlegen der Spannungssequenz eine Lage des Läufers (3) bestimmt wird und ein statorfestes Koordinatensystem initial auf die bestimmte Lage ausgerichtet wird.

3. Verfahren nach Anspruch 1 oder 2, **dadurch gekennzeichnet, dass** beim Anlegen der Spannungssequenz eine Mehrzahl von Spannungszeigern ausgegeben wird und für jeder der Spannungszeiger ein Messwert für den elektrischen Strom ($i_1$ bis $i_4$) bestimmt wird.

4. Verfahren nach Anspruch 3, **dadurch gekennzeichnet, dass** beim Anlegen der Spannungssequenz vier Spannungszeiger ausgegeben werden.

5. Verfahren nach Anspruch 3, **dadurch gekennzeichnet, dass** beim Anlegen der Spannungssequenz acht Spannungszeiger ausgegeben werden.

6. Verfahren nach einem der Ansprüche 3 bis 5, **dadurch gekennzeichnet, dass** eine Impulsdauer, während welcher die jeweiligen Spannungszeiger ausgegeben werden, in Abhängigkeit von einer geschätzten Auslenkung des Läufers (3) bestimmt wird.

7. Verfahren nach einem der vorhergehenden Ansprüche, **dadurch gekennzeichnet, dass** die Spannungssequenz derart vorgeben wird, dass die resultierenden Statorflüsse ($\Psi_1$ bis $\Psi_4$) äquidistant sind.

8. Verfahren nach einem der Ansprüche 1 bis 6, **dadurch gekennzeichnet, dass** die Spannungssequenz in Abhängigkeit von bekannten Sättigungscharakteristiken von Synchronreluktanzmaschinen (1) vorgegeben wird.

**9.** Verfahren nach einem der vorhergehenden Ansprüche, **dadurch gekennzeichnet, dass** die Ströme ($i_1$ bis $i_4$) für einen Quadraten des Läufers (3) bestimmt werden und die Sättigungscharakteristik anhand einer bekannten Symmetrie des Läufers (3) bestimmt wird.

**10.** Vorrichtung (6) zum Bestimmen einer Sättigungscharakteristik einer Synchronreluktanzmaschine (1) umfassend

- einen Pulswechselrichter (4) zum Anlegen einer Spannungssequenz an einen Stator (2) der Synchronreluktanzmaschine (1) und zum Einprägen von Statorflüssen ($\Psi_1$ bis $\Psi_4$), und
- eine Messeinrichtung (5) zum Messen von elektrischen Strömen ($i_1$ bis $i_4$), welche aus den Statorflüssen ($\Psi_1$ bis $\Psi_4$) resultieren,
- wobei die Vorrichtung (6) dazu ausgebildet ist, die Sättigungscharakteristik anhand der Statorflüsse ($\Psi_1$ bis $\Psi_4$) und der gemessenen Ströme ($i_1$ bis $i_4$) zu bestimmen,

**dadurch gekennzeichnet, daß** der Pulswechselrichter (4) dazu ausgelegt ist,
die Spannungssequenz derart anzulegen, daß sich während des Anlegens der Spannungssequenz auf einen Läufer (3) der Synchronreluktanzmaschine (1) wirkende Drehmomente (Mi bis M4 ) aufheben.

**Claims**

**1.** Method for determining a saturation characteristic of a synchronous reluctance machine (1) comprising the steps of:

- applying a voltage sequence to a stator (2) of the synchronous reluctance machine (1) by means of a pulse inverter (4) and thereby introducing stator fluxes ($\Psi_1$ to $\Psi_4$),
- measuring electrical currents ($i_1$ to $i_4$) which result from the stator fluxes ($\Psi_1$ to $\Psi_4$) and
- determining the saturation characteristic on the basis of the stator fluxes ($\Psi_1$ to $\Psi_4$) and the measured currents ($i_1$ to $i_4$),

**characterised in that** the voltage sequence is applied in such a way that torques ($M_1$ to $M_4$) acting on a rotor (3) of the synchronous reluctance machine (1) cancel each other out during the application of the voltage sequence.

**2.** Method according to claim 1, **characterised in that** before the application of the voltage sequence, a position of the rotor (3) is determined, and a stator-fixed coordinate system is initially aligned to the determined position.

**3.** Method according to claim 1 or 2, **characterised in that** when the voltage sequence is applied, a plurality of voltage indicators is output and a measured value for the electrical current ($i_1$ to $i_4$) is determined for each of the voltage indicators.

**4.** Method according to claim 3, **characterised in that** when the voltage sequence is applied, four voltage indicators are output.

**5.** Method according to claim 3, **characterised in that** when the voltage sequence is applied, eight voltage indicators are output.

**6.** Method according to one of claims 3 to 5, **characterised in that** a pulse duration during which the respective voltage indicators are output is determined as a function of an estimated deflection of the rotor (3).

**7.** Method according to one of the preceding claims, **characterised in that** the voltage sequence is specified in such a way that the resulting stator fluxes ($\Psi_1$ to $\Psi_4$) are equidistant.

**8.** Method according to one of claims 1 to 6, **characterised in that** the voltage sequence is specified as a function of known saturation characteristics of synchronous reluctance machines (1) .

**9.** Method according to one of the preceding claims, **characterised in that** the currents ($i_1$ to $i_4$) are determined for a quadrant of the rotor (3) and the saturation characteristic is determined on the basis of a known symmetry of the rotor (3).

**10.** Apparatus (6) for determining a saturation characteristic of a synchronous reluctance machine (1) comprising

- a pulse inverter (4) for applying a voltage sequence to a stator (2) of the synchronous reluctance machine (1) and for imprinting stator fluxes ($\Psi_1$ to $\Psi_4$), and
- a measuring facility (5) for measuring electrical currents ($i_1$ to $i_4$) resulting from the stator fluxes ($\Psi_1$ to $\Psi_4$),
- wherein the apparatus (6) is designed to determine the saturation characteristic on the basis of the stator fluxes ($\Psi_1$ to $\Psi_4$) and the measured currents ($i_1$ to $i_4$),

**characterised in that** the pulse inverter (4) is designed to apply the voltage sequence in such a way that torques ($M_1$ to $M_4$) acting on a rotor (3) of the synchronous reluctance machine (1) cancel each other out during the application of the voltage sequence.

## Revendications

1. Procédé de détermination d'une caractéristique de saturation d'une machine (1) à réluctance synchrone comprenant les stades :

    - on applique une séquence de tension à un stator (2) de la machine (1) à réluctance synchrone au moyen d'un onduleur (4) à impulsion et on imprime ainsi des flux ($\Psi_1$ à $\Psi_4$) statoriques,
    - on mesure des courants ($i_1$ à $i_4$) électriques, qui proviennent des flux ($\Psi_1$ à $\Psi_4$) statoriques et
    - on détermine la caractéristique de saturation au moyen des flux ($\Psi_1$ à $\Psi_4$) statoriques et des courants ($i_1$ à $i_4$) mesurés,

    **caractérisé en ce que** l'on applique la séquence de tension de manière à supprimer, pendant l'application de la séquence de tension, des couples (Mi à M4) s'appliquant à un rotor (3) de la machine (1) à réluctance synchrone.

2. Procédé suivant la revendication 1, **caractérisé en ce qu'**avant l'application de la séquence de tension, on détermine une position du rotor (3) et on établit un système de coordonnées lié invariablement au stator initialement sur la position déterminée.

3. Procédé suivant la revendication 1 ou 2, **caractérisé en ce que** lors de l'application de la séquence de tension, on sort une pluralité de vecteurs de tension et, pour chaque vecteur de tension, on détermine une valeur de mesure du courant ($i_1$ à $i_4$) électrique.

4. Procédé suivant la revendication 3, **caractérisé en ce que**, lors de l'application de la séquence de tension, on sort quatre vecteurs de tension.

5. Procédé suivant la revendication 3, **caractérisé en ce que**, lors de l'application de la séquence de tension, on sort huit vecteurs de tension.

6. Procédé suivant l'une des revendications 3 à 5, **caractérisé en ce que** l'on détermine, en fonction d'une excursion estimée du rotor (3), une durée d'impulsion pendant laquelle on sort les vecteurs de tension respectifs.

7. Procédé suivant l'une des revendications précédentes, **caractérisé en ce que** l'on prescrit la séquence de tension de manière à ce que les flux ($\psi_1$ à $\psi_4$) statoriques résultant soient équidistants.

8. Procédé suivant l'une des revendications 1 à 6, **caractérisé en ce que** l'on prescrit la séquence de tension en fonction de caractéristiques de saturation connues de machines (1) à réluctance synchrone.

9. Procédé suivant l'une des revendications précédentes, **caractérisé en ce que** l'on détermine les courants ($i_1$ à $i_4$) d'un cadran du rotor (3) et on détermine la caractéristique de saturation à l'aide d'au moins d'une symétrie connue du rotor (3) .

10. Dispositif (6) de détermination d'une caractéristique de saturation d'une machine (1) à réluctance synchrone comprenant

    - un onduleur (4) à impulsion pour l'application d'une séquence de tension à un stator (2) de la machine (1) à réluctance synchrone et pour l'impression de flux ($\psi_1$ à $\psi_4$) statoriques, et
    - un dispositif (5) de mesure pour la mesure de courants ($i_1$ à $i_4$) électriques, qui proviennent des flux ($\psi_1$ à $\psi_4$)

statoriques,

- dans lequel le dispositif (6) est constitué pour déterminer la caractéristique de saturation à l'aide des flux ($\psi_1$ à $\psi_4$) et des courants ($i_1$ à $i_4$) mesurés,

**caractérisé en ce que** l'onduleur (4) à impulsion est conçu pour appliquer la séquence de tension de manière à supprimer, pendant l'application de la séquence de tension, des couples (Mi à M4) s'appliquant au rotor (3) de la machine (1) à réluctance synchrone.

FIG 1

FIG 2

FIG 3

FIG 4

FIG 5

FIG 6

FIG 7

FIG 8

## FIG 9

## FIG 10

FIG 11

FIG 12

**IN DER BESCHREIBUNG AUFGEFÜHRTE DOKUMENTE**

**In der Beschreibung aufgeführte Patentdokumente**

- JP 2002095289 A